**Europäisches Patentamt**

**European Patent Office**

**Office européen des brevets**

(19)

(11) Veröffentlichungsnummer: **0 402 750**

**A1**

# (12) EUROPÄISCHE PATENTANMELDUNG

(21) Anmeldenummer: **90110673.2**

(22) Anmeldetag: **06.06.90**

(51) Int. Cl.5: **C08J 7/14, C23C 18/24,** **//C08L77:00**

(30) Priorität: **14.06.89 DE 3919367**

(43) Veröffentlichungstag der Anmeldung:
**19.12.90 Patentblatt 90/51**

(84) Benannte Vertragsstaaten:
**BE DE FR GB NL SE**

(71) Anmelder: **BASF Aktiengesellschaft**
**Carl-Bosch-Strasse 38**
**D-6700 Ludwigshafen(DE)**

(72) Erfinder: **Betz, Walter, Dr.**
**Weimarer Strasse 45**
**D-6700 Ludwigshafen(DE)**
Erfinder: **Blinne, Gerd, Dr.**
**Im Woogtal 7**
**D-6719 Bobenheim(DE)**

(54) **Verfahren zur Oberflächenbehandlung von Polyamid-Formkörpern und danach erhaltene Formkörper.**

(57) Verfahren zur Oberflächenbehandlung von Formkörpern auf der Basis von Polyamiden durch Behandlung mit wäßrigen Säuren, wobei man als wäßrige Säure eine 30- bis 85 %ige Lösung von $H_3PO_4$ verwendet, nach diesem Verfahren erhältliche Formkörper und deren Verwendung.

EP 0 402 750 A1

## Verfahren zur Oberflächenbehandlung von Polyamid-Formkörpern und danach erhaltene Formkörper

Die vorliegende Erfindung betrifft ein Verfahren zur Oberflächenbehandlung von Formkörpern auf der Basis von Polyamiden durch Behandlung mit wäßrigen Säuren.

Darüber hinaus betrifft die Erfindung nach diesem Verfahren erhältliche Formkörper sowie deren Verwendung zur Metallisierung, d.h. zur Beschichtung mit Metallen.

Polyamide zählen zur Klasse der technischen Kunststoffe und haben in vielen Bereichen weite Verbreitung gefunden.

Ein interessantes Anwendungsgebiet, nämlich der Bereich der metallisierten Werkstoffe ist den Polyamiden bislang jedoch weitgehend verschlossen geblieben. Dies hat seine Ursache hauptsächlich in der unzureichenden Haftung der Metallschicht auf dem Polyamid. Diese Problematik wird in einem Artikel von Seidenspinner (Galvanotechnik 75 (1984), 852) diskutiert und verschiedene Lösungsansätze, z.B. die Behandlung mit wäßriger Salzsäure, angedeutet. In Galvanotechnik 79 (1988), 54 wird ein Verfahren zur Oberflächenbehandlung von Polyamid-Spritzgußteilen beschrieben, nach dem zunächst in einem Palladiumsalze enthaltenden Bad aktiviert und anschließend in einem Calcium- und Aluminiumsalze enthaltenden Bad die Oberfläche aufgerauht wird. Dieses Verfahren ist zum einen wegen der teuren verwendeten Materialien wirtschaftlich von Nachteil, zum anderen können auch die erzielten Haftfestigkeiten noch nicht voll zufriedenstellen.

Aus der EP-A 56 986 sind Polyamid-Formmassen bekannt, die 30 bis 60 Gew.% Wollastonit als Füllstoff enthalten und sich besonders zur Metallisierung eignen. Die Vorbehandlung wird mit einer 4 bis 15 %igen Lösung von Salzsäure oder Schwefelsäure durchgeführt, wobei durch Angriff an den Füllstoffpartikeln eine Aufrauhung der Oberfläche erzielt wird, d.h. der Füllstoff ist zur Erreichung guter Haftungswerte zwischen Metall und Polyamid zwingend erforderlich. Durch den hohen Füllstoffgehalt wird jedoch die Qualität der Oberfläche beeinträchtigt, was bei Anwendungen im dekorativen Bereich von Nachteil ist.

Aufgabe der vorliegenden Erfindung war es daher, ein Verfahren zur Oberflächenbehandlung von Formkörpern auf der Basis von Polyamiden zur Verfügung zu stellen, die anschließend gut metallisierbar sein sollten, und welches die vorstehend geschilderten Nachteile nicht aufweist.

Diese Aufgabe wird erfindungsgemäß durch ein Verfahren zur Oberflächenbehandlung von Formkörpern auf der Basis von Polyamiden durch Behandlung mit wäßrigen Säuren gelöst, wobei man als wäßrige Säure eine 30- bis 85 gew.%ige Lösung von $H_3PO_4$ verwendet. Die Angaben in Gewichtsprozent beziehen sich auf eine Temperatur von 20 °C; bei höheren Temperaturen sind auch $H_3PO_4$-Lösungen mit einem Gehalt von mehr als 85 Gew.% erhältlich.

Das erfindungsgemäße Verfahren eignet sich zur Oberflächenbehandlung von Formkörpern auf der Basis von Polyamiden, d.h. Formkörper, die als einen wichtigen Bestandteil ein thermoplastisches Polyamid enthalten. Dieses kann gegebenenfalls mit Füllstoffen, die Schlagzähigkeit verbessernden Polymeren, weiteren Polymeren oder mit Flammschutzmitteln modifiziert sein.

Geeignete Polyamide sind an sich bekannt und umfassen die halbkristallinen und amorphen Harze mit Molekulargewichten (Gewichtsmittelwerten) von mindestens 5000, die gewöhnlich als Nylon bezeichnet werden. Solche Polyamide sind z.B. in den amerikanischen Patentschriften 2 071 250, 2 071 251, 2 130 523, 2 130 948, 2 241 322, 2 312 966, 2 512 606 und 3 393 210 beschrieben.

Die Polyamide können z.B. durch Kondensation äquimolarer Mengen einer gesättigten oder einer aromatischen Dicarbonsäure mit 4 bis 12 Kohlenstoffatomen, mit einem Diamin, welches 4 bis 14 Kohlenstoffatome aufweist, hergestellt werden, oder durch Kondensation von $\omega$-Aminocarbonsäuren oder Polyaddition von Lactamen. Beispiele für Polyamide sind Polyhexamethylenadipinsäureamid (Nylon 66), Polyhexamethylenazelainsäureamid (Nylon 69), Polyhexamethylensebacinsäureamid (Nylon 610), Polyhexamethylendodecandisäureamid (Nylon 612), die durch Ringöffnung von Lactamen erhaltenen Polyamide, wie Polycaprolactam, Polylaurinsäurelactam, ferner Poly-11-aminoundecansäure und ein Polyamid aus Di(p-aminocyclohexyl)-methan- und Dodecandisäure. Es ist auch möglich, Polyamide zu verwenden, die durch Copolykondensation von zwei oder mehr der obengenannten Polymeren oder ihrer Komponenten hergestellt worden sind, z.B. ein Copolymeres aus Caprolactam, Terephthalsäure und Hexamethylendiamin. Vorzugsweise sind die Polyamide linear und haben Schmelzpunkte von mehr als 200 °C.

Bevorzugte Polyamide sind Polyhexamethylenadipinsäureamid Polyhexamethylensebacinsäureamid und Polycaprolactam. Die Polyamide weisen im allgemeinen eine relative Viskosität von 2,5 bis 5 auf, bestimmt an einer 1 gew.%igen Lösung in 96 %iger Schwefelsäure bei 23 °C, was einem Molekulargewicht (Gewichtsmittelwert) von etwa 15.000 bis etwa 45.000 entspricht. Polyamide mit einer relativen Viskosität von 2,5 bis 4,0, insbesondere 2,6 bis 3,5, werden bevorzugt verwendet.

Verfahren zur Herstellung solcher Polyamide sind an sich bekannt und in der Literatur beschrieben.

Eine weitere Gruppe besonders geeigneter Polyamide sind die in der EP-A 299 444 beschriebenen teilaromatischen Copolyamide aus ε-Caprolactam, Terephthalsäure und Hexamethylendiamin oder Adipinsäure, Terephthalsäure und Hexamethylendiamin. Wegen näherer Einzelheiten zu diesen Polyamiden sei auf die EP-A 299 444 selbst verwiesen.

Füllstoffe, schlagzäh modifizierende Polymere und Flammschutzmittel für Polyamide sind dem Fachmann an sich bekannt und in der Literatur beschrieben, so daß sich hier nähere Angaben erübrigen.

Nur stellvertretend sei hier als Mischung von Polyamid und einem anderen Polymeren ein Polymer-Blend aus Polyamid und Polyphenylenether genannt.

Die Herstellung der Formkörper aus den vorstehend beschriebenen Polyamidformmassen kann nach den dem Fachmann bekannten Verfahren, z.B. durch Extrusion, Spritzguß oder Blasformen, um nur 3 Verfahren zu nennen, erfolgen. Die Verarbeitungsbedingungen hängen natürlich von der Zusammensetzung der Polyamidformmasse ab und sind dem Fachmann bekannt.

Die Oberflächenbehandlung der Formkörper auf der Basis von Polyamiden erfolgt mit Hilfe einer 30- bis 85-, vorzugsweise 40- bis 75 gew.%igen Lösung von Phosphorsäure ($H_3PO_4$). Zeitdauer und Temperatur der Behandlung hängen dabei voneinander ab; je höher die Temperatur, desto kürzer in der Regel die Behandlungsdauer.

Bevorzugt wird eine Temperatur im Bereich von 10 bis 60, insbesondere von 15 bis 45 °C.

Die Behandlungsdauer liegt vorzugsweise im Bereich von 5 bis 120, insbesondere von 10 bis 60 s, besonders bevorzugt von 10 bis 30 s.

Es hat sich als vorteilhaft herausgestellt, wenn bei einer Konzentration der Phosphorsäure von 40 bis 75 Gew.% das Produkt aus Behandlungstemperatur in Grad Celsius und der Behandlungsdauer in Sekunden im Bereich von 200 bis 2400 liegt, da bei der Metallisierung derart vorbehandelter Formkörper besonders gute Haftfestigkeitswerte erzielt werden.

Darüber hinaus hat es sich als vorteilhaft herausgestellt, wenn die zur Oberflächenbehandlung verwendete Phosphorsäure weitere Zusätze enthält.

Beispiele für weitere Zusätze sind

a) wäßrige Lösungen eines kationische Gruppen enthaltenden Polyvinylimidazols oder

b) organische Ether der allgemeinen Formel

$R^2O\text{-}(CH_2)_n\text{-}OR^1$,

wobei

$R^1$ Wasserstoff oder eine $C_1$-$C_{10}$-Alkylgruppe oder eine Arylgruppe,

$R^2$ Wasserstoff oder eine $C_1$-$C_{10}$-Alkylgruppe oder eine Arylgruppe und

n eine ganze Zahl von 2 bis 10 bedeutet

oder

c) Chloride eines zwei- oder vierwertigen Metalls.

Unter einem kationische Gruppen enthaltenden Polyvinylimidazols sollen erfindungsgemäß Polyvinylimidazole verstanden werden, die ein quarternäres Stickstoffkation enthalten.

Derartige Zusätze sind allgemein bekannt und im Handel erhältlich (z.B. Basotronic® PVI). Für weitere Einzelheiten sei auf die DE-A 37 43 740 verwiesen sowie auf die DE-A 37 43 741, DE-A 37 43 742, DE-A 37 43 743 und DE-A 37 43 744, in denen weitere quaternäre Gruppen enthaltende Polymere beschrieben sind, die ebenso als Zusatz a) verwendet werden können.

Organische Ether der obigen allgemeinen Formel enthalten bevorzugt einen Wasserstoffrest $R^1$ oder $R^2$ und n = 2, wobei Ethylenglykolmonomethylether besonders bevorzugt ist.

Die Zusätze a) oder b) sind in Mengen von 0,1 bis 30 Gew.-%, vorzugsweise von 0,5 bis 20 Gew.-% und insbesondere von 1 bis 15 Gew.-%, bezogen auf 100 Gew.-% der Oberflächenbehandlungslösung, enthalten. Darüber hinaus können auch Mischungen der Zusätze a) und b) verwendet werden, wobei das Mischungsverhältnis beliebig ist.

Als Beispiele für Zusätze c) seien Chloride des Zinks und Zinns genannt, die in Mengen von 0,1 bis 10 g, vorzugsweise 0,2 bis 8 g, bezogen auf 1 l wäßrige $H_3PO_4$, enthalten sind.

Nach der Vorbehandlung werden die Formkörper vorteilhafterweise durch Spülen in Wasser von anhaftenden Säureresten befreit.

Im Anschluß daran kann dann der Formkörper in üblicher, an sich bekannter Weise metallisiert werden.

Hierzu wird in der Regel zunächst aktiviert, dann reduziert und anschließend chemisch metallisiert, woran sich die galvanische Metallisierung als letzter Schritt anschließt.

Dabei werden Produkte erhalten, die sich durch besonders hohe Haftfestigkeiten, im allgemeinen im Bereich von 1,25 bis 5 N/mm (gemessen nach DIN 53289 im Rollenschälversuch), auszeichnen. Die Produkte, welche mit wäßriger $H_3PO_4$ und den Zusätzen a) bis c) vorbehandelt wurden, zeichnen sich durch eine insgesamt glatte, kaum angerauhte Oberfläche aus und erzielen neben hohen auch einheitliche

3

Haftfestigkeiten über die gesamte Oberfläche des Formkörpers.

Durch die Behandlung mit der Phosphorsäure werden die in der Oberflächenschicht enthaltenen Aminogruppen des Polyamids durch Reaktion mit $H_3PO_4$ modifiziert, wobei zur Erzielung besonders guter Ergebnisse in einer Oberflächenschicht von max. 100 $\mu$m Dicke mindestens 5 mol% der ursprünglich vorhandenen Aminogruppen verändert werden.

Aus dem Vorstehenden geht bereits hervor, daß sich die erfindungsgemäßen Formkörper insbesondere zur anschließenden Metallisierung eignen. Die so erhaltenen metallisierten Formkörper können in vielen Bereichen, z.B. im Automobilsektor oder auf dem Gebiet der Elektrotechnik und Elektronik eingesetzt werden. Besonders erwähnt sei hier die Verwendung von Formkörpern auf der Basis von teilaromatischen Copolyamiden gemäß der EP-A 299 444 zur Herstellung spritzgegossener Leiterplatten.

Darüber hinaus lassen sich nach dem erfindungsgemäßen Verfahren behandelte Formkörper auch gut lackieren und bedrucken.

Beispiele

Eine 2,0 mm dicke Platte aus einem teilaromatischen Copolyamid, aufgebaut aus Einheiten, die sich von $\epsilon$-Caprolactam und Terephthalsäure/Hexamethylendiamin im Gewichtsverhältnis von 70:30 aufbauen (hergestellt nach Beispiel 1 der EP-A 299 444) mit einer relativen Viskosität von 2,50, gemessen in 96 %iger $H_2SO_4$ (1 g/100 ml) bei 25° C, wurde mit einer wäßrigen Lösung von $H_3PO_4$, die die in der Tabelle angegebene Temperatur hatte, über die in der Tabelle angegebenen Zeiträume behandelt. Anschließend wurde die erhaltene Platte mit destilliertem Wasser abgespült und getrocknet.

Die Metallisierung erfolgt in an sich bekannter Weise, wobei als Endresultat eine 25-50 $\mu$m dicke Kupferschicht auf der Polyamid-Platte erhalten wurde.

Die Ergebnisse des Rollenschälversuchs nach DIN 53289 und der Temperaturwechselprüfung nach DIN 53496 sind ebenfalls in der Tabelle aufgeführt.

Zum Vergleich wurden gleiche Polyamidplatten mit wäßrigen Lösungen anderer Säuren (gemäß Tabelle) vorbehandelt und in identischer Weise metallisiert. Die Ergebnisse sind ebenfalls der Tabelle zu entnehmen.

Tabelle

| Vers.-Nr. | verwendete Säure | Behandlung Temp. | Behandlung Zeit | mittl. Schälwiderstand N/mm (nach DIN 53289) | Temperaturwechselprüfung (nach DIN 53496) |
|---|---|---|---|---|---|
| 1 | $H_3PO_4$ conc. | RT[2) ] | 20 sec | > 3,0 | bestanden |
| 2 | 70 % $H_3PO_4$ | 40°C | 10 sec | 0,5-0,8 | " |
| 3 | 70 % $H_3PO_4$ | 40°C | 20 sec | 1,5-3,0 | " |
| 4 | 70 % $H_3PO_4$ | 40°C | 30 sec | 2,0-4,5 | " |
| 5 | 95 Gew.% 85 % $H_3PO_4$+ 5 Gew.% Zusatz a) | RT | 20 sec | 1,1-1,3 | bestanden |
| 6*) | 95 Gew.% 70 % $H_3PO_4$+ 5 Gew.% Zusatz a) | RT | 300 sec | 1,1-1,3 | bestanden |
| 7 | 90 Gew.% 85 % $H_3PO_4$+ 10 Gew.% Zusatz b) | RT | 30-60 sec | 0,6-0,9 | bestanden |
| 8 | 85 Gew.% 85 % $H_3PO_4$+ 15 Gew.% Zusatz b) | RT | 30-60 sec | 0,6-0,9 | bestanden |
| 9*) | 85 Gew.% 70 % $H_3PO_4$+ 15 Gew.% Zusatz b) | RT | 300 sec | 0,6-0,9 | bestanden |
| 10 V | HCl conc. | 30°C | 20 sec | -1 | nicht bestanden |
| 11 V | 20 % HCl | RT | 10-1200 sec | < 0,1 | " " |
| 12 V | $H_2SO_4$ | RT | 10-420 sec | < 0,1 | " " |
| 13 V | Chromschwefelsäure | RT | 20 sec | -1 | " " |
| 14 V | HCOOH (75 Gew.%) | RT | 420 sec | 0,1-0,3 | " " |

EP 0 402 750 A1

Tabelle (Forts.)

| Vers.-Nr. | verwendete Säure | Behandlung | | mittl. Schälwiderstand | Temperaturwechselprüfung |
| | | Temp. | Zeit | N/mm (nach DIN 53289) | (nach DIN 53496) |
|---|---|---|---|---|---|
| 15 V | $CH_3COOH$ conc. | RT | 10-1800 sec | < 0,1 | nicht bestanden |
| 16 V | $HNO_3$ conc. | RT | 20 sec | < 0,1 | "          " |
| 17 V | $CCl_3COOH$ conc. | 60°C | 30 sec | < 0,1 | "          " |
| 18 V | NaOCl + HCl conc. | 60°C | 10-7200 sec | < 0,1 | "          " |

V = Vergleichsversuch

[1] keine Haftung meßbar, da Formkörper durch eingesetzte Säure zerstört wird

[2] RT = Raumtemperatur (21°C)

*) Versuche 6 und 9 wurden auf automatisierte Prozesse mit 5 Min. Takt (Verweilzeit im Vorbehandlungsbad) optimiert.

Zusatz a) quaternäres Stickstoffkation enthaltendes Polyvinylimidazol (40 %ige Lösung in Wasser)

Zusatz b) Ethylenglykolmonomethylether

EP 0 402 750 A1

**Ansprüche**

1. Verfahren zur Oberflächenbehandlung von Formkörpern auf der Basis von Polyamiden durch Behandlung mit wäßrigen Säuren, dadurch gekennzeichnet, daß man als wäßrige Säure eine 30- bis 85 gew.%ige Lösung von $H_3PO_4$ verwendet.

2. Verfahren nach Anspruch 1, dadurch gekennzeichnet, daß man die Behandlung mit $H_3PO_4$ bei einer Temperatur im Bereich von 10 bis 60 °C durchführt.

3. Verfahren nach einem der Ansprüche 1 oder 2, dadurch gekennzeichnet, daß man die Behandlung mit $H_3PO_4$ über einen Zeitraum von 5 bis 120 sec durchführt.

4. Verfahren nach den Ansprüche 1 bis 3, dadurch gekennzeichnet, daß die zur Behandlung der Oberfläche verwendete $H_3PO_4$ 0,1 bis 30 Gew.-% einer wäßrigen Lösung eines kationische Gruppen enthaltenden Polyvinylimidazols enthält.

5. Verfahren nach den Ansprüchen 1 bis 4, dadurch gekennzeichnet, daß die wäßrige $H_3PO_4$ 0,1 bis 10 g/l eines Chlorids eines zwei- oder vierwertigen Metalls enthält.

6. Verfahren nach den Ansprüchen 1 bis 5, dadurch gekennzeichnet, daß die zur Behandlung der Oberfläche verwendete wäßrige $H_3PO_4$ 0,5 bis 30 Gew.-% eines organischen Ethers enthält.

7. Formkörper, erhältlich gemäß dem Verfahren nach den Ansprüchen 1 bis 6.

8. Polyamid-Formkörper in denen in einer Oberflächenschicht von maximal 100 μm Dicke mindestens 5 mol% der ursprünglich vorhandenen Aminogruppen durch Reaktion mit $H_3PO_4$ modifiziert sind.

9. Verwendung der Formkörper gemäß den Ansprüchen 7 und 8 oder wie gemäß den Ansprüchen 1 bis 6 erhalten, zur Metallisierung, Lackierung und Bedruckung.

**Europäisches Patentamt**

**EUROPÄISCHER RECHERCHENBERICHT**

Nummer der Anmeldung

EP 90 11 0673

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | CHEMICAL ABSTRACTS, Band 81, Nr. 20, 18. November 1974, Seite 127, Zusammenfassung Nr. 122724g, Columbus, Ohio, US; & JP-A-74 10 318 (TOYOBO CO., LTD) 09-03-1974 --- | 1,3,7,8 | C 08 J 7/14<br>C 23 C 18/24 //<br>C 08 L 77:00 |
| Y | IDEM --- | 1-3,7-9 | |
| X | CHEMICAL ABSTRACTS, Band 82, Nr. 24, 16. Juni 1975, Seite 57, Zusammenfassung Nr. 157459x, Columbus, Ohio, US; & JP-A-75 00 076 (ASAHI CHEMICAL INDUSTRY) 06-01-1975 --- | 1,2,7,8 ,9 | |
| Y | IDEM ----- | 1-3,7-9 | |

**RECHERCHIERTE SACHGEBIETE (Int. Cl.5)**

C 08 J
C 23 C

Der vorliegende Recherchenbericht wurde für alle Patentansprüche erstellt

| Recherchenort | Abschlußdatum der Recherche | Prüfer |
|---|---|---|
| DEN HAAG | 21-09-1990 | HALLEMEESCH A.D. |